# EUROPEAN PATENT APPLICATION

(11) **EP 4 819 414 A1**
(43) Date of publication of application: **07.10.2026**
(21) Application number: 26169626.4
(22) Date of filing: 31.03.2026
(51) Int. Cl.: H01R 43/00, B60L 53/16, G01R 31/69, H01R 13/66, H01R 13/443

(54) **CONNECTOR HEALTH MONITORING DEVICE**

(30) Priority: 04.04.2025 US 202563783548 P; 26.06.2025 US 202519250454
(71) Applicant: TE Connectivity Solutions GmbH, 8200 Schaffhausen (CH)
(72) Inventor: VENKATESAN, Ram Kishore, 27101-2166 Winston, Salem (US); SARRAF, David Bruce, 17057 Middletown (US); MYER, Nathan Philip, 17057 Middletown (US); ANGELL, Paul, 27101-2167 Winston, Salem (US); HETRICK, Ryan, 17057 Middletown (US); HITCHCOCK, Matthew Bryan, 17057 Middletown (US); SHOEMAKER, Joshua T, 27101-2166 Winston, Salem (US); PATTERSON, Jeremy Christin, 27101-2166 Winston, Salem (US)
(74) Representative: Ashton, Gareth Mark

(57) **Abstract**

A connector health monitoring device (100) for health assessment testing of an electrical connector includes a device housing (140) that includes a body (142) forming a cavity (150). The device housing has a mating end (112) configured for mating with the electrical connector. The connector health monitoring device includes a control element (160) received in the cavity. The control element includes a processor (165) for performing a health assessment of the electrical connector. The connector health monitoring device includes a testing probe (110) held by the device housing. The testing probe includes a mating interface (102) for mating with a testable contact of the electrical connector. The testing probe arranged at the mating end for mating with the testable contact. The testing device is operably coupled to the control element.

## Description

This application claims priority to US Application No. 63/783,548, filed 04-April-2025 and US Patent Application No. 19/250,454 filed on 26-June-2025, the subject matter of which is herein incorporated by reference in its entirety.

The subject matter herein relates to electrical connector health monitoring.

Electrical connectors are subject to wear and damage over time. For example, electrical connectors that are subject to numerous mate and unmate cycles and/or electrical connectors that are operated in harsh environments are subject to wear and damage over time. Additionally, the presence of foreign objects or debris at the separable connector interface is problematic and can lead to damage to the electrical connector components. Some known electrical connectors that suffer from such problems are charging connectors used for electrical charging. For example, the transition from Internal Combustion Engine (ICE) vehicles to Electric Vehicles (EVs) has introduced significant challenges in ensuring safe charging, particularly at the charging interface. This interface, where the vehicle connects to the charging station, is an example of a high voltage interface that is subjected to varying amounts of environmental exposure and therefore is susceptible to damage or degradation in the field. Charging components are made robust to handle charging plugs of varying quality and conditions. There is a need to develop solutions for sensing the health of the connection systems to enable predictive maintenance. One of the major implications of a bad connection is an increase in heat loss which reduces the overall charging efficiency. The decrease in charging efficiency translates to an increase in charging power or duration. This increased cost due to a bad connection is charged back to the vehicle owner and it results in poor experience for the end user. In certain cases, the bad connection can also result in irreversible damage on the vehicle inlets that would require servicing or replacement. All the above factors reiterate the ever increasing need to detect and enable routine maintenance of the charging plugs and separable interfaces that are out in the field that are susceptible to damage from exposure to contaminants. Other types of connectors other than charging connectors suffer from similar deterioration and need for maintenance.

There is a need for a connector health monitoring device that provides a reliable way of assessing connector health at separable mating interfaces.

In an embodiment, a connector health monitoring device for health assessment testing of an electrical connector is provided. The connector health monitoring device includes a device housing that includes a body forming a cavity. The device housing has a mating end configured for mating with the electrical connector. The connector health monitoring device includes a control element received in the cavity. The control element includes a processor for performing a health assessment of the electrical connector. The connector health monitoring device includes a testing probe held by the device housing. The testing probe includes a mating interface for mating with a testable contact of the electrical connector. The testing probe is arranged at the mating end for mating with the testable contact. The testing device or probe is operably coupled to the control element. The processor may perform the health assessment of the electrical connector based on the signals from the testing probe. For example, the testing probe may monitor for foreign object(s) at the mating interface with the testable contact.

The connector health monitoring device may comprise a camera held by the device housing, the camera configured to image the testable contact of the electrical connector, and processor may perform the health assessment based on the signals from the testing probe and images from the camera.

In another embodiment, a connector health monitoring device for health assessment testing of an electrical connector is provided. The connector health monitoring device comprises a device housing including a body forming a cavity, the device housing having a first mating end at a first end of the device housing configured for mating with the electrical connector, the device housing including a second mating end at a second side of the device housing, wherein the first mating end has a first layout for mating with a first type of the electrical connector and the second mating end has a second layout for mating with a second type of the electrical connector. A first testing probe is held by the device housing, the first testing probe including a first mating interface at the first mating end for mating with a testable contact of the electrical connector (16) of the first type. A second testing probe is held by the device housing, the second testing probe including a second mating interface at the second mating end for mating with a testable contact of the electrical connector of the second type. A control element is received in the cavity, the control element being operably coupled to the first testing probe to receive signals from the first testing probe and being operably coupled to the second testing probe to receive signals from the second testing probe, the control element including a processor for performing a health assessment of the electrical connector based on the received signals from the first testing probe or the second testing probe.

The figure will be described by way of example with reference to the accompanying Figures of which:
Figure 1 illustrates a connector health monitoring device in accordance with an exemplary embodiment.
Figure 2 is a front view of the connector health monitoring device in accordance with an exemplary embodiment.
Figure 3 is a rear view of the connector health monitoring device in accordance with an exemplary embodiment.
Figure 4 is an exploded view of the connector health monitoring device in accordance with an exemplary embodiment.
Figure 5 is a front perspective view of the connector health monitoring device in accordance with an exemplary embodiment.
Figure 6 is a rear perspective view of the connector health monitoring device in accordance with an exemplary embodiment
Figure 7 is a front perspective view of the connector health monitoring device in accordance with an exemplary embodiment.
Figure 8 is a rear perspective view of the connector health monitoring device shown in Figure 7 in accordance with an exemplary embodiment.
Figure 9 illustrates a charging health monitoring system in accordance with an exemplary embodiment.

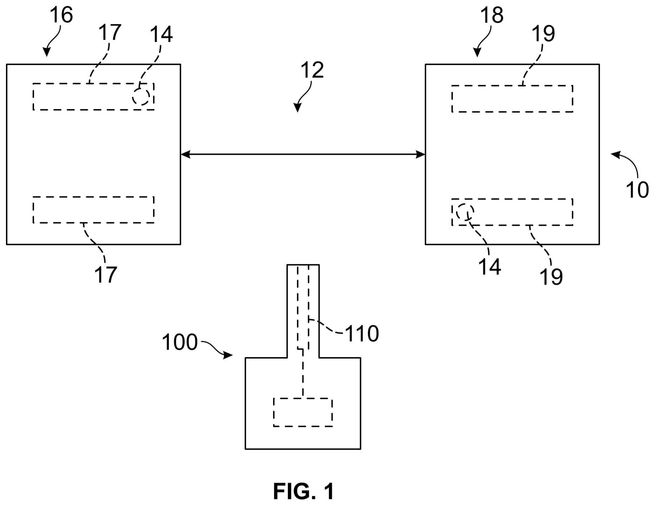

Figure 1 illustrates a connector health monitoring device 100 in accordance with an exemplary embodiment. The connector health monitoring device 100 is used for assessing health of the mating interface of one or more electrical connectors 10. For example, the connector health monitoring device 100 may assess health of a separable connector interface 12 of the electrical connector (s), such as for foreign object debris (FOD) 14 and/or for wear of the contacts or terminals thereof and/or to assess operational status of the contacts or terminals thereof. In an exemplary embodiment, the electrical connectors 10 at the separable connector interface 12 include a first electrical connector 16 and a second electrical connector 18. The connector health monitoring device 100 may be used to test the interface of the first electrical connector 16 and/or the second electrical connector 18. In an exemplary embodiment, the connector health monitoring device 100 is used to test electrical terminals or contacts 17 of the first electrical connector 16 and/or electrical terminals or contacts 19 of the second electrical connector 18.

In an exemplary embodiment, the connector health monitoring device 100 comprises one or more testing probes 110 configured to be mated with the testable contacts of the electrical connector(s) 10 at the separable connector interface 12. The testing probe 110 may be plugged into the interface of the first electrical connector 16 and/or the second electrical connector 18. For example, the testing probe 110 may be mated with the electrical terminals 17 of the first electrical connector 16 and/or the electrical terminals 19 of the second electrical connector 18 for testing the electrical terminals 17, 19.

In an exemplary embodiment, the connector health monitoring device 100 includes a testing probe 110 associated with the testing probe 110. The testing probe 110 is used to measure one or more health assessment characteristics of the testable contact and/or the electrical connector 10 at the separable connector interface 12. For example, the health assessment characteristics may include mating force, electrical characteristics, contact resistance, contact wear, emissivity, contact size, contact shape, presence of FOD, and the like. Optionally, multiple testing probes 110 may be provided for testing different health assessment characteristics and/or for testing different electrical terminals or different areas of the separable connector interface 12. In an exemplary embodiment, the testing arrangement is configured for multi-parameter health assessment analysis of the separable connector interface 12.

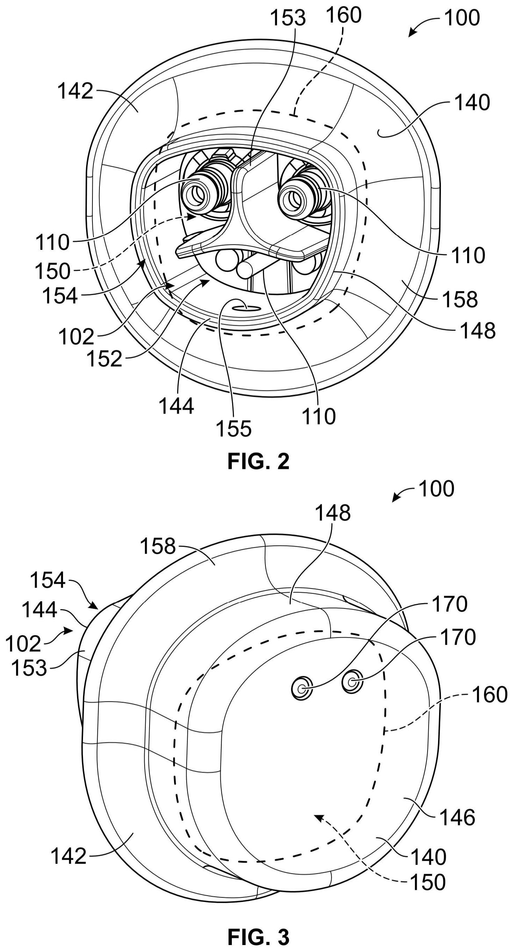

Figure 2 is a front view of the connector health monitoring device 100 in accordance with an exemplary embodiment. Figure 3 is a rear view of the connector health monitoring device 100 in accordance with an exemplary embodiment. The connector health monitoring device 100 includes a mating interface 102 configured to be mated with the electrical connector 10 during a testing operation. The mating interface 102 is sized and shaped to interface with the electrical connector 10. In various embodiments, the mating interface 102 may have a standard interface for mating with the electrical connector 10. For example, the mating interface 102 may have a standard power charging interface, such as for an electric vehicle. However, the connector health monitoring device 100 is not limited to testing power charging interfaces of an electric vehicle. In various embodiments, the mating interface 102 may mimic a mating interface of a charging inlet of an electric vehicle such that the connector health monitoring device mimics the mating interface of a charging inlet of an electric vehicle for testing a charging plug of a charging station. For example, the mating interface 102 may be a CCS1 charging interface, a NACS charging interface, or another type of standard charging interface for electric vehicle.

The connector health monitoring device 100 includes a device housing 140 holding one or more of the testing probes 110. The device housing 140 holds a control element 160 operably coupled to the testing probes 110. The control element 160 includes one or more processors for performing a health assessment of the electrical connector 10. In an exemplary embodiment, the connector health monitoring device 100 may include one or more indicators 170 operably coupled to the control element 160. The indicators 170 may provide a visual indication, audible indication, or other type of indication to the operator indicative of the connector health of the electrical connector 10 during the testing operation. For example, the indicators 170 may include LED lights to provide a visual indication to the operator, such as a green light and a red light to indicate good health or poor health, respectively. Other types of indicators may be used in alternative embodiments.

The device housing 140 includes a body 142 extending between a front 144 and a rear 146 of the device housing 140. In the illustrated embodiment, the indicators 170 are provided at the rear 146. Other locations are possible in alternative embodiments. In an exemplary embodiment, the body 142 may be manufactured from a dielectric material, such as a plastic material. For example, the body 142 may be a molded part, such as an injection molded part. The body 142 may be a multipiece body having multiple pieces coupled together to form the device housing 140. The body 142 includes walls 148 surrounding a cavity 150. The control element 160 is received in the cavity 150. The testing probes 110 may extend into the cavity 150. Other components may be housed within the cavity 150 and surrounded by the body 142. In various embodiments, the cavity 150 may be enclosed, such as being entirely surrounded by the body 142. In various embodiments, the body 142 may be sealed to provide a sealed environment for the components held within the cavity 150.

In an exemplary embodiment, the walls 148 form a socket or receptacle 152 configured to receive a portion of the electrical connector 10. In the illustrated embodiment, the receptacle 152 is located at the front 144. The testing probes 110 are located within the receptacle 152. For example, the testing probes 110 may be surrounded by the walls 148 forming the receptacle 152. In alternative embodiments, the testing probes 110 may extend forward of the device housing 140. In an exemplary embodiment, the device housing 140 includes a separating wall 153 extending into the receptacle 152 that separates the receptacle 152 into different chambers. Each of the chambers may receive the corresponding testing probe 110. For example, the separating wall 153 separates the testing probes 110 from each other. Optionally, multiple testing probes 110 may be located in each chamber. The walls 148 and/or the separating wall 153 may include keying features, alignment features, or other types of locating features to guide mating with the electrical connector 10.

In an exemplary embodiment, the device housing 140 includes a mating end 154 configured to be mated with the electrical connector 10. In the illustrated embodiment, the mating end 154 is located at the front 144. Other locations are possible in alternative embodiments. In various embodiments, the device housing 140 may include multiple mating ends configured to be mated to different types of electrical connectors 10. For example, the mating ends may be provided at the front 144 and the rear 146 for mating with different electrical connectors 10. In an exemplary embodiment, the device housing 140 includes one or more latching mechanisms 155 for latching engagement with the electrical connector 10. In various embodiments, the latching mechanisms 155 may be deflectable latches. Other types of latching mechanisms may be used in alternative embodiments, such as a fixed latch mechanism, a catch, a clip, or other type of latching mechanism. In alternative embodiments, other types of securing means, such as fasteners, straps, clips, locks, and the like may be used to secure the device housing 140 to the electrical connector 10.

In an exemplary embodiment, the device housing 140 includes a handle 158 for holding the device housing 140. The handle 158 may extend from one or more the sides of the device housing 140. The handle 158 may extend from the front 144 and/or the rear 146. In the illustrated embodiment, the handle 158 is formed by a circumferential flange that extends radially outward from the device housing 140, such as at the sides, the top, and the bottom thereof. Other locations are possible in alternative embodiments. The handle 158 may include finger grips or other features to allow the user to hold the device housing 140.

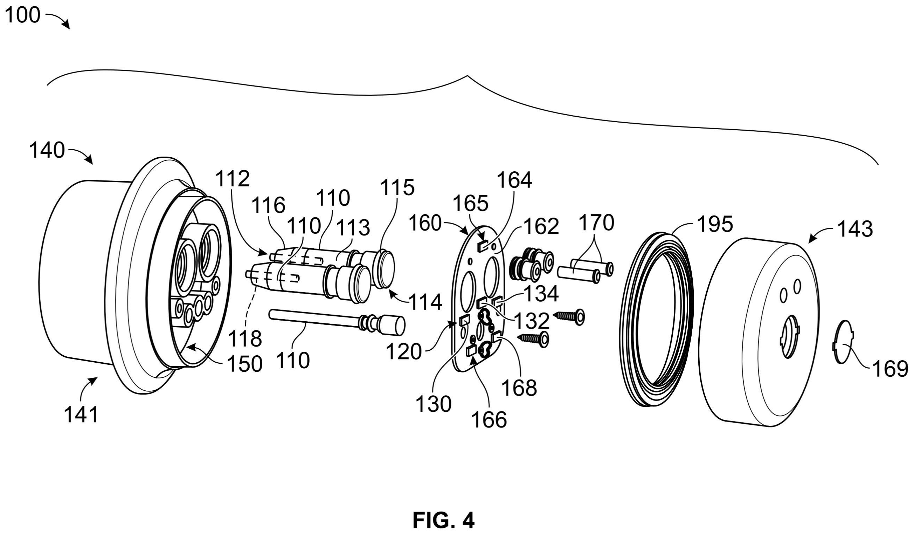

Figure 4 is an exploded view of the connector health monitoring device 100 in accordance with an exemplary embodiment. Figure 4 shows the device housing 140, the testing probes 110, and the control element 160 in accordance with an exemplary embodiment. The control element 160 and the testing probes 110 may be held by the device housing 140.

In the illustrated embodiment, the device housing 140 is a multipiece housing including a front housing 141 and the rear housing 143 configured to be coupled together. In an exemplary embodiment, a peripheral seal 195 is configured to be located between the front housing 141 and the rear housing 143 to provide a sealed interface between the front housing 141 and the rear housing 143 the peripheral seal 195 is configured to seal the cavity 150.

Each testing probe 110 extends between a mating end 112 and a terminating end 114. The mating end 112 includes a mating interface 113 configured to be mated with the testable contact of the electrical connector 10. Optionally, the testing probe 110 may have a graphite layer or other low wear layer to improve wear resistance of the connector interface and extend the life of the electrical connector 10 and/or the testing device, which may reduce maintenance frequency. The terminating end 114 is configured to be electrically connected to the control element 160. In various embodiments, the testing probe 110 may include a probe seal 115 at the terminating end 114 configured to be sealed to the device housing 140 or other component within the device housing 140. In the illustrated embodiment, the testing probes 110 are pins at the mating end 112. In alternative embodiments, the testing probes 110 may be sockets at the mating end 112. Other types of testing probes may be used in alternative embodiments. In various embodiments, the testing probes 110 may include touch proof caps 116 at the mating end 112 to prevent inadvertent touching of the mating end 112. The testing probes 110 may be cylindrical, such as having a diameter. In various embodiments, the diameter may be equal to a diameter of a charging pin for a charging inlet of an electric vehicle such that the connector health monitoring device mimics the mating interface of a charging inlet of an electric vehicle for testing a charging plug of a charging station.

The control element 160 is configured to be held by the device housing 140 and may be received in the cavity 150, such as between the front housing 141 and the rear housing 143. The control element 160 is configured to be operably coupled to the testing probes 110 and receives signals from the testing probes 110 and/or transmit signals to the testing probes 110. The control element 160 includes circuitry for measuring and analyzing signals from the testing probes 110 for performing a health assessment of the electrical connector 10 during the testing operation.

In an exemplary embodiment, the control element 160 includes a printed circuit board 162, a control module 164 mounted to the printed circuit board 162 and a communication module 166 coupled to the printed circuit board 162. The control element 160 may include a geolocation element to identify a location of the connector health monitoring device 100 during testing, such as using GPS or other location based tracking device, such as to identify the location of the electrical connector being tested. In an exemplary embodiment, the control element 160 may include a battery 168 for powering one or more components of the control element 160. The battery 168 is configured to be positioned in the cavity 150 of the device housing 140. The battery 168 may be rechargeable. The battery 168 may be accessed through the rear housing 143. The battery 168 may be covered by a battery cover 169, which may be removable, such as for charging of the battery 168.

In an exemplary embodiment, the indicators 170 are coupled to the printed circuit board 162. Other types of output devices, such as a user interface (not shown) may be coupled to the printed circuit board 162 to provide output to the user. The indicators 170 may pass through openings in the device housing 140, such as the rear housing 143. The indicators 170 may include LEDs to provide visual indication to the user. Other types of indicators may be used in alternative embodiments.

The printed circuit board 162 includes a substrate having one or more layers. The printed circuit board 162 includes circuits including conductors printed on one or more layers of the substrate. The circuits may include conductors, traces, vias, pads, or other type of circuit elements. One or more electrical components may be coupled to the circuits. In an exemplary embodiment, the testing probes 110 are terminated to the printed circuit board 162. For example, the testing probes 110 may be soldered to circuits of the printed circuit board 162 or connected via contacts to the printed circuit board 162. The substrate of the printed circuit board 162 may be secured to the device housing 140, such as using fasteners.

In an exemplary embodiment, the testing probes 110 are coupled to the printed circuit board 162. The testing probes 110 may be communicatively coupled to the testing sensors 120. For example, the testing sensor 120 may receive signals from the testing probes 110. The signals may be transmitted through one or more circuits of the printed circuit board 162. The testing sensors 120 may be separate components from the testing probes 110 and/or the control module 164. In alternative embodiments, the testing sensors 120 may be integrated with the control module 164 or the testing probes 110. The testing probe 110 is used to measure one or more health assessment characteristics of the testable contact and/or the electrical connector 10 at the separable connector interface 12. For example, the health assessment characteristics may include mating force, electrical characteristics, contact resistance, contact wear, emissivity, contact size, contact shape, presence of FOD, and the like. Optionally, multiple testing probes 110 may be provided for testing different health assessment characteristics and/or for testing different electrical terminals or different areas of the separable connector interface 12. In an exemplary embodiment, the testing arrangement is configured for multi-parameter health assessment analysis of the separable connector interface 12. The testing probe 110 may be a force sensor configured to measure mating forces at the testing probe 110. The testing probe 110 may be an electrical sensor configured to measure current, voltage, amperage, and the like. The testing probe 110 may be a proximity sensor configured to measure proximity and/or distance to the testable contact or other component of the electrical connector. The testing probe 110 may be an image sensor configured to analyze digital images or other types of images.

The control module 164 includes one or more electrical components, such as processors, IC components, memory devices, a CMOS sensor, a field programmable gate array (FPGA), a digital signal processor (DSP), and the like. For example, the control module 164 includes one or more processors 165 for performing a health assessment of the electrical connector 10 based on signals received from the testing probes 110. In an exemplary embodiment, the control module 164 may be programmable. For example, the control module 164 may receive over-the-air update signals, such as to update the analysis software or algorithms. During operation of the control module 164, the control module 164 runs programs to analyze the health assessment signals. For example, the control module 164 operates programs stored in one or more memories on the processor 165. The health assessment from the data analysis may be used for to allow/disallow connection or operation of the electrical connector, for scheduled maintenance, to evaluate efficiency (for example, power conversion efficiency to predict charging time based on use of the electrical connector 10).

The processor(s) 165 may include computer system executable instructions, such as program modules, being executed by a computer system. Generally, program modules may include routines, programs, objects, components, logic, data structures, and so on that perform particular tasks or implement particular abstract data types. The computing may be practiced in distributed cloud computing environments where tasks are performed by remote processing devices that are linked through a communications network. In a distributed cloud computing environment, program modules may be located in both local and remote computer system storage media including memory storage devices.

In an exemplary embodiment, various components may be communicatively coupled by a bus, such as the memory and the processors 165. The bus represents one or more of any of several types of bus structures, including a memory bus or memory controller, a peripheral bus, an accelerated graphics port, and a processor or local bus using any of a variety of bus architectures.

The control module 164 may include a variety of computer system readable media. Such media may be any available media that is accessible by the control module 164, and it includes both volatile and non-volatile media, removable and non-removable media. The memory can include computer system readable media in the form of volatile memory, such as random access memory (RAM) and/or cache memory. The control module 164 may further include other removable/non-removable, volatile/non-volatile computer system storage media. By way of example only, a storage system can be provided for reading from and writing to a non-removable, non-volatile magnetic media (not shown and typically called a "hard drive"). Although not shown, a magnetic disk drive for reading from and writing to a removable, non-volatile magnetic disk (e.g., a "floppy disk"), and an optical disk drive for reading from or writing to a removable, non-volatile optical disk such as a CD-ROM, DVD-ROM or other optical media can be provided. In such instances, each can be connected to the bus by one or more data media interfaces. The memory may include at least one program product having a set (e.g., at least one) of program modules that are configured to carry out the functions of embodiments of the invention.

One or more programs may be stored in the memory, as well as an operating system, one or more application programs, other program modules, and program data. Each of the operating system, one or more application programs, other program modules, and program data or some combination thereof, may include an implementation of a networking environment. Program modules generally carry out the functions and/or methodologies of embodiments of the subject matter described herein.

The control module 164 may also communicate with one or more external devices, such as through the communication module 166 of the control module 164, for data sharing and/or analysis by remote testing devices. The communication module 166 may communicate with the electrical connector or the system incorporating the electrical connector 10 (for example, the charging station or the electric vehicle). The communication module 166 may communicate with the user, such as through a mobile device (for example, cell phone app or vehicle display system). In various embodiments, the communication module 166 is configured to communicate wirelessly, such as via Bluetooth, Wi-Fi, or other wireless protocol. In other various embodiments, the communication module 166 may communicate through the testing probes 110 or other contacts, such as to the electrical connector 10. The health data may be shared with the electrical connector, or the system associated with the electrical connector, for maintenance or to alert other users of the health of the electrical connector. The external devices may include a keyboard, a pointing device, a display, and the like; one or more devices that enable a user to interact with system; one or more mobile devices (such as a mobile phone or mobile testing unit); one or more devices associated with the electrical connector 10 (such as the charging station, the electric vehicle, and the like); and/or any devices (e.g., network card, modem, etc.) that enable the system to communicate with one or more other computing devices. Such communication can occur via Input/Output (I/O) interfaces. Still yet, the control module 164 can communicate with one or more networks such as a local area network (LAN), a general wide area network (WAN), and/or a public network (e.g., the Internet) via network adapter. Other hardware and/or software components could be used in conjunction with the system components shown herein. Examples include, but are not limited to: microcode, device drivers, redundant processing units, and external disk drive arrays, RAID systems, tape drives, and data archival storage systems, etc.

The term "processor" as used herein is intended to include any processing device, such as, for example, one that includes a CPU (central processing unit) and/or other forms of processing circuitry. Further, the term "processor" may refer to more than one individual processor. The term "memory" is intended to include memory associated with a processor or CPU, such as, for example, RAM (random access memory), ROM (read only memory), a fixed memory device (for example, hard drive), a removable memory device (for example, diskette), a flash memory and the like. In addition, the phrase "input/output interface" as used herein, is intended to contemplate an interface to, for example, one or more mechanisms for inputting data to the processing unit (for example, mouse), and one or more mechanisms for providing results associated with the processing unit (for example, printer). The processor 165, memory, and input/output interface can be interconnected, for example, via the bus as part of a data processing unit. Suitable interconnections, for example via bus, can also be provided to a network interface, such as a network card, which can be provided to interface with a computer network, and to a media interface, such as a diskette or CD-ROM drive, which can be provided to interface with suitable media.

Accordingly, computer software including instructions or code for performing the methodologies of the subject matter herein may be stored in one or more of the associated memory devices (for example, ROM, fixed or removable memory) and, when ready to be utilized, loaded in part or in whole (for example, into RAM) and implemented by a CPU. Such software could include, but is not limited to, firmware, resident software, microcode, and the like.

It should be noted that any of the methods described herein can include an additional step of providing a system comprising distinct software modules embodied on a computer readable storage medium; the modules can include, for example, any or all of the appropriate elements depicted in the block diagrams and/or described herein; by way of example and not limitation, any one, some or all of the modules/blocks and or sub-modules/sub-blocks described. The method steps can then be carried out using the distinct software modules and/or sub-modules of the system, as described above, executing on one or more hardware processors. Further, a computer program product can include a computer-readable storage medium with code adapted to be implemented to carry out one or more method steps described herein, including the provision of the system with the distinct software modules.

In an exemplary embodiment, the testing probe 110 includes a pogo pin 118 for mating with the separable connector interface 12, such as the testable contact of the electrical connector 10. The testing probe 110 may include other types of testing elements in alternative embodiments. In an exemplary embodiment, the testing probe 110 may be removable and replaceable. For example, the testing probe 110 may be threadably coupled to the device housing 140 and/or the control module 164 to allow removal and replacement of the testing probe 110. The testing probe 110 may be removed and replaced for testing different separable connector interfaces. For example, different sized (length and/or diameter) testing probes 110 may be used. Testing sensors having different types of testing elements may be utilized by removing and replacing the different testing probes 110.

In an exemplary embodiment, the testing sensors 120 associated with the testing probe 110 includes a force measurement sensor 130 for sensing mating force with the separable connector interface 12. The force measurement sensor 130 may sense a compression force of the pogo pin 118, such as to detect for FOD.

In an exemplary embodiment, the testing sensors 120 associated with the testing probe 110 includes an electrical resistance measurement sensor 132 for sensing electrical resistance with the separable connector interface 12, such as the testable contact. The electrical resistance measurement sensor 132 senses electrical resistance between the pogo pin 118 and the testable contact.

In an exemplary embodiment, the testing sensors 120 associated with the testing probe 110 includes a position measurement sensor 134 for sensing a mated position of the testing probe 110 with the separable connector interface 12. The position measurement sensor 134 may include at least one of an optical sensor, a laser measurement sensor, and a proximity sensor for sensing the mated position of the testing probe 110 with the separable connector interface 12. The position measurement sensor 134 may detect a position of the testing probe 110 relative to the testable contact and/or the housing of the electrical connector 10, such as the position of the pogo pin 118. The position measurement sensor 134 may detect a length of the pogo pin 118 and/or an amount of compression of the pogo pin 118.

In an exemplary embodiment, the testing probe 110 is mated with the separable connector interface 12 to a mated position. An amount of compression of the pogo pin 118 at the mated position may be different when FOD is present compared to when no foreign object is present at the separable connector interface 12. In an exemplary embodiment, the pogo pin 118 is configured to be electrically connected to an electrical terminal 17 at the separable connector interface 12. A measurement of electrical resistance between the pogo pin 118 and the electrical terminal 17 may change when FOD is present at the separable connector interface 12 compared to when no foreign object is present at the separable connector interface 12. For example, if the FOD is made from a different material than the electrical terminal 17 then the electrical resistance may change, which may be indicative of presence of the FOD. If the FOD is made from a dielectric material, such as plastic or rubber, then the FOD is non-conductive and the electrical connection between the pogo pin 118 and the electrical terminal 17 is lost, indicative of presence of the FOD. The connector health monitoring device 100 may be used for foreign object detection in separable interfaces.

In an exemplary embodiment, the connector health monitoring device 100 integrates various sensing or measurement techniques, such as resistance measurement and force measurement. The connector health monitoring device 100 may use the pogo pin 118 to detect the presence of foreign objects, such as by simultaneously measuring electrical resistance and applied force. In an exemplary embodiment, the pogo pin 118 is designed with an end diameter matching the socket opening for precise FOD detection. The pogo pin 118 may feature a screw-on head that is removable and replaceable to accommodate specific geometries. The pogo pin 118 can be made of plastic for FOD-only applications or can be made of metal for combined FOD and electrical measurements. In other various embodiments, the testing probe 110 may be used to measure other characteristics, such as mating force, contact wear, or other characteristics to assess the health of the testable contact and/or the housing of the electrical connector 10.

In an exemplary embodiment, the testing probe 110 may measure emissivity of the testable contact to assess health of the testable contact. For example, the corresponding testing sensor 120 may measure how efficiently the surface of the testable contact emits thermal radiation. The control module 164 uses the emissivity measurement to determine contact wear. For example, based on the emissivity difference between silver and copper, the control module 164 may predict the amount of wear on the mating interface surface of the testable contact, such as to determine if maintenance is required. The control module 164 may perform a projected area analysis for more accurate wear assessment.

In an exemplary embodiment, the connector health monitoring device 100 may integrate the testing probe 110 into a connector design, such as into the charging inlet or charging plug used for charging, such as electric vehicle charging. The connector health monitoring device 100 may leverage the testing properties to automatically assess the connector health, such as the health of the contacts and/or to detect the presence of FOD before full mating occurs. The testing probe 110 may be carefully calibrated to make contact with the testable contact for accurate assessment of the health of the testable contact. The assessment mechanism can be implemented through various means, such as electrical resistance measurement, mechanical pressure sensors, or optical sensors monitoring the connection. The automated testing approach eliminates the need for visual inspection, provides real-time feedback, and significantly reduces the risk of connector damage or system malfunction due to poor connector health.

The connector health monitoring device 100 offers several advantages. It may provide improved accuracy by combining FOD detection with resistance and force measurement, offering a more comprehensive analysis of the interface condition. The design's versatility allows for both FOD-only applications and combined FOD/electrical measurement applications. The system's customizability enables adaptation to various interface geometries. The connector health monitoring device 100 provides multi-parameter analysis capability to allow it to differentiate between various types of foreign objects and interface conditions by correlating pin position, electrical continuity, and applied force. The connector health monitoring device 100 performs health assessment in separable interfaces to offer a significant improvement over existing methods by providing a multi-faceted analysis of the interface condition. The integration of resistance and force measurement capabilities alongside FOD detection enables more accurate and reliable identification of potential issues in critical connections. In various embodiments, imaging analysis may additionally be utilized to further improve the health assessment analysis.

The connector health monitoring device 100 can be a separate handheld testing device. In other various embodiments, the connector health monitoring device 100 can be integrated into the connectors at the connector interface, such as into the charging inlet or charging plug. The connector health monitoring device 100 may be integrated into various types of connector systems and is not limited to use in electric vehicle charging. The connector health monitoring device 100 can be used for detection at OEM assembly, by service technicians, or by tier I/II suppliers. The connector health monitoring device 100 can be used for FOD detection by a user, such as by a cellphone or other mobile device interface. In various embodiments, the connector health monitoring device 100 may be integrated into assembly robots. For example, the connector health monitoring device 100 may be integrated into robot end effectors that are able to test interfaces during assembly. For example, the robot end effector may check for FOD before assembling connectors in high pollution environments. The connector health monitoring device 100 may be used for testing a charging port of the robot, such as an automated guide vehicle (AGV) or other autonomous industrial vehicle, or may be used for testing the charging station associated with the vehicle prior to docking for charging.

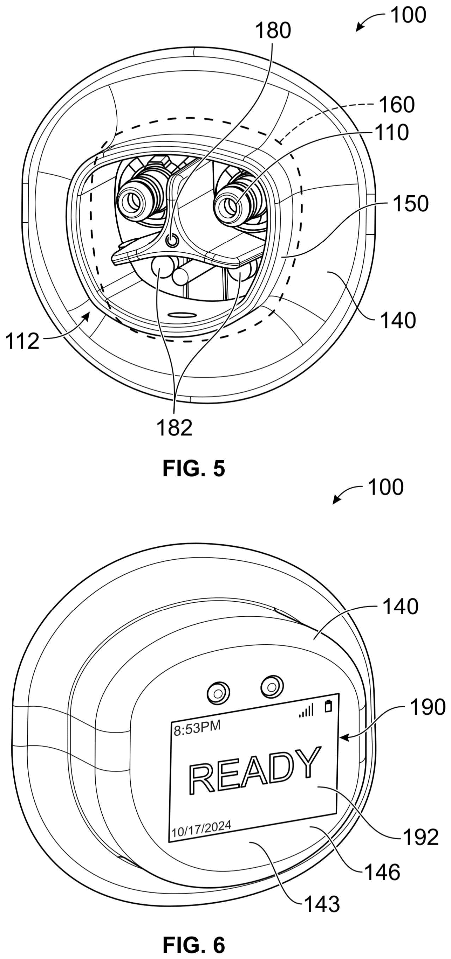

Figure 5 is a front perspective view of the connector health monitoring device 100 in accordance with an exemplary embodiment. In the illustrated embodiment, the connector health monitoring device 100 includes a camera 180 at the mating end 112 for imaging the electrical connector 10. The camera 180 is operably coupled to the control element 160.

The images from the camera 180 may be analyzed by the control element 160 to provide a health assessment of the electrical connector 10. For example, the images may be analyzed to identify the positions of the testable contacts relative to each other or relative to the connector housing. The images may be analyzed to determine the size of the testable contacts and/or the spacing between the testable contacts and the connector housing. The images may be analyzed to identify FOD at the mating interface. The images may be analyzed to identify damage, wear, or other problems with the testable contacts. The images may be used in addition to other testing signals of the testing probes 110 to provide the health assessment of the electrical connector 10. The images from the camera may be used for positioning of the connector health monitoring device 100 relative to the electrical connector 10. For example, for automated testing (for example, connector health monitoring device 100 incorporated into an end effector of an assembly robot), the images may be used to align the connector health monitoring device 100 with the electrical connector 10 during testing. Other types of alignment mechanisms may be used for aligning the components or for aligning the camera 180 with the mating interface, such as a laser alignment mechanism, a proximity detector, and the like.

The control element 160 may use an image processing module and/or image processing algorithm and/or image processing software to analyze the image. The image processing may include boundary detection, color detection, lighting detection, image segmentation, edge detection, color mapping, feature extraction, image enhancement, color space conversion, illumination correction, and the like. The images may be analyzed by the control element 160 or may be analyzed by a remote device. For example, the images may be transmitted to another device and/or the cloud for analysis offline. The control element 160 or other device used for analysis may include an AI learning module for enhanced or improved imaging analysis based on the images.

In the illustrated embodiment, the camera 180 is located at the separating wall 150. Other locations are possible in alternative embodiments, the camera 180 is positioned to view the components of the electrical connector 10, such as the testable contacts, the housing, or other parts of the electrical connector 10. The images may be analyzed to identify FOD in the housing and/or around the contacts, damaged or missing contacts, damaged portions of the housing, or other elements that may affect the health of the electrical connector 10. The images may be analyzed to observe or predict wear of the contacts. The images may be analyzed to look for soot, plastic, or other debris on the contacts that could affect electrical conductivity of the contacts.

In an exemplary embodiment, the connector health monitoring device 100 includes a lighting element 182 held by the device housing 140. The lighting element is configured to illuminate the electrical connector 10, such as the testable contact, the housing, or other components of the electrical connector 10. The lighting element 182 is used to improve the imaging by the camera 180. The lighting element 182 may measure ambient lighting to determine an intensity, color, or other lighting characteristic to enhance the imaging by the camera 180.

Figure 6 is a rear perspective view of the connector health monitoring device 100 in accordance with an exemplary embodiment in the illustrated embodiment, the connector health monitoring device 100 includes a user interface 190 coupled to the device housing 140. For example, the user interface 190 may be integrated into the rear housing 143 and accessible at the rear 146.

In an exemplary embodiment, the user interface 190 includes a display 192 configured to display information to the user, such as operational status, data indicative of the health assessment, communication status, battery status, or other information. In various embodiments, the display 192 may be a touch screen to allow control by the user. In other various embodiments, the user interface 190 may include other inputs, such as a keypad, buttons, sliders, dials, or other types of user inputs. In alternative embodiments, the user inputs may be made through a remote device, such as a mobile device communicatively coupled to the connector health monitoring device 100.

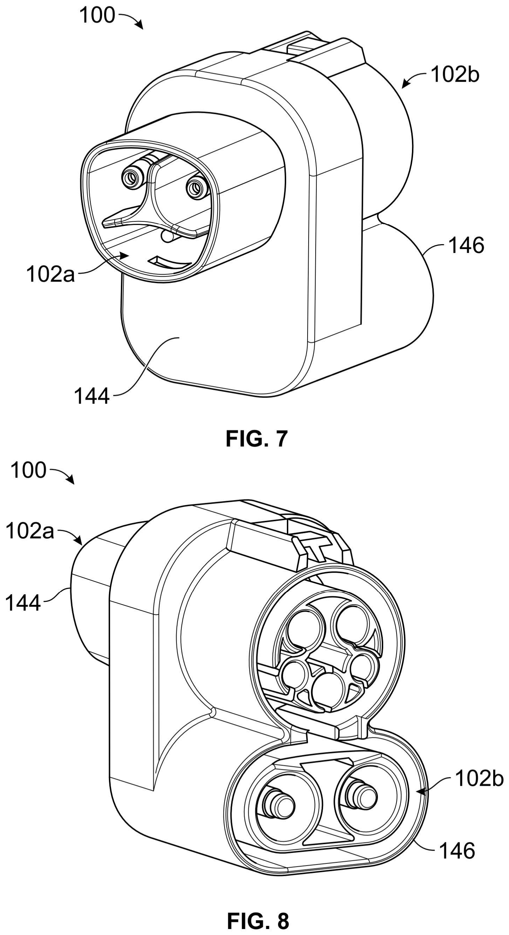

Figure 7 is a front perspective view of the connector health monitoring device 100 in accordance with an exemplary embodiment. Figure 8 is a rear perspective view of the connector health monitoring device 100 shown in Figure 7. In the illustrated embodiment, the connector health monitoring device 100 includes a first mating interface 102a at the front 144 and a second mating interface 102b at the rear 146. The first mating interface 102a may be a NACS charging interface and the second mating interface 102b may be a CCS1 charging interface. Other types of interfaces may be used in alternative embodiments. Providing different types of mating interfaces on the same connector health monitoring device allows testing of different types of electrical connectors using the same connector health monitoring device.

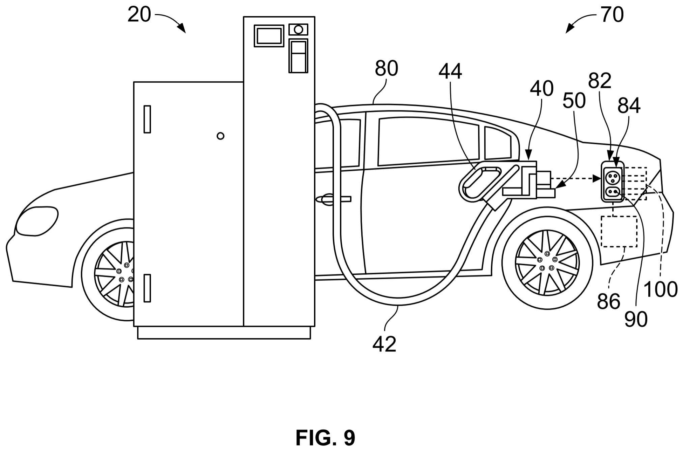

Figure 9 illustrates a charging health monitoring system 70 in accordance with an exemplary embodiment. The charging health monitoring system 70 includes the connector health monitoring device 100. The monitoring device 100 is used for monitoring health of charging terminals used for charging an electric vehicle 80. The charging health monitoring system 70 measures charging interface health when the vehicle 80 is connected to a charging station 20.

The connector health monitoring device 100 may be used to detect for presence of foreign objects at the charging interface before charging occurs and/or during charging. The connector health monitoring device 100 may be used to assess health of the charging terminals at the charging interface before charging occurs and/or during charging. The charging health monitoring system 70 may provide a signal that allows or disallows charging based on the measured health of that particular separable interface and/or based on FOD detection. The charging health monitoring system 70 reduces dissatisfaction with low charging rates, the potential for harmful user intervention (jiggling the charging plug to increase charging rate) or damage to the inlet and charging plug due to poor interface health.

The connector health monitoring device 100 may be incorporated into the electric vehicle 80 and/or the charging station 20 for charging the electric vehicle 80 to monitor health of the charging components, such as to control the charging operation. For example, the connector health monitoring device 100 may allow or disallow the charging operation based on the health of the charging terminals and/or based on FOD detection. In an exemplary embodiment, the connector health monitoring device 100 measures interface resistance at the interface of the charging terminals to determine a health of the charging components and/or to detect presence of FOD. If the interface resistance is too high, the connector health monitoring device 100 may disallow the charging operation leading the operator to use a different charging station 20 and/or to repair or replace the charging components to improve the charging operation.

The electric vehicle 80 includes a charging inlet 82 having charging terminals 90. In an exemplary embodiment, the charging inlet 82 includes a receptacle configured to receive a charging plug. In various embodiments, the charging inlet 82 is operable as a standard type charging inlet, such as an SAE J1772 inlet. In an exemplary embodiment, the charging terminals 90 are pin terminals. However, other types of charging terminals may be used in alternative embodiments. The charging inlet 82 is mounted to the vehicle 80. The charging inlet 82 is electrically connected to a battery 86 of the electric vehicle 80. The charging terminals 90 are supplied power from the charging station 20 to recharge the battery 86. The connector health monitoring device 100 may be integrated into the charging inlet, such as being integrated with the charging terminals 90.

The charging station 20 includes a charging plug 40 at an end of a charging cable 42. The charging plug 40 is configured to be mated with the charging inlet 82. The charging station 20 supplies power to the charging plug 40 to charge the electric vehicle 80. The charging plug 40 may be a Level 1 charger, a Level 2 charger or a Level 3 charger. In an exemplary embodiment, the charging plug may be a DC fast charging plug. The charging plug 40 may be any type of electric vehicle charging interface having an arrangement of charging terminals, such as a combined charging system (CCS) having both AC charging terminals and DC charging terminals. The charging plug 40 includes a handle 44 holding charging terminals 50. In an exemplary embodiment, the charging terminals 50 are charging sockets. The charging terminals 50 are configured to be received in the receptacle 84 to mate with the charging terminals 90 of the charging inlet 82.

In various embodiments, the connector health monitoring device 100 are part of the electric vehicle 80. For example, the connector health monitoring device 100 may be part of the charging inlet 82. The connector health monitoring device 100 may be part of the battery system. In other various embodiments, the connector health monitoring device 100 are part of the charging station 20. For example, the connector health monitoring device 100 may be part of the charging plug 40. The connector health monitoring device 100 may control the power supply from the charging station 20 to the charging inlet 82. For example, the connector health monitoring device 100 may shut off the charging operation if the health of the charging components at the charging interface is determined to be unhealthy and/or if FOD is detected. For example, if there is high electrical resistance at the charging interface, such as due to damage or deterioration or due to the presence of foreign objects, the charging operation may be disallowed. In an exemplary embodiment, the connector health monitoring device 100 enables individual consumers, fleet owners, charging station maintenance contractors, or other individuals to assess the health of the charging plug 40 and determine if any maintenance and/or replacement of the charging plug 40 or components thereof is required. The connector health monitoring device 100 measures the resistance of the connection in the charging plug 40 to determine the health of the charging terminals 50. In an exemplary embodiment, the connector health monitoring device 100 compares the measured resistance with a known database of connections ranging from good to poor and provides the user with an indication of health of the particular charging terminals 50 to determine if the charging terminals 50 need service or replacement. The connector health monitoring device 100 may provide an output to the user indicative of the health of the charging terminals 50 and/or the presence of FOD, which may be displayed at the charging station 20 and/or within the electric vehicle 80 and/or at a mobile device.

## Claims

1. A connector health monitoring device (100) for health assessment testing of an electrical connector (10), the connector health monitoring device comprising:
a device housing (140) including a body (142) forming a cavity (150), the device housing having a mating end (112) configured for mating with the electrical connector;
a control element (160) received in the cavity, the control element including a processor (165) for performing a health assessment of the electrical connector; and
a testing probe (110) held by the device housing, the testing probe including a mating interface (102) for mating with a testable contact of the electrical connector, the testing probe arranged at the mating end for mating with the testable contact, the testing probe operably coupled to the control element.

2. The connector health monitoring device (100) of claim 1, wherein the control element (160) provides an output indicative of health of the electrical connector (10) based on the health assessment.

3. The connector health monitoring device (100) of claim 1 or 2, wherein the device housing (140) includes walls (148) forming a socket at the mating end (112), the testing probe (110) located in the socket.

4. The connector health monitoring device (100) of claim 1, 2 or 3, wherein the testing probe (110) is a first testing probe, the connector health monitoring device further comprising a second testing probe at the mating end (112) for mating with a second testable contact of the electrical connector (10).

5. The connector health monitoring device (100) of any preceding claim, wherein the mating end (112) is a first mating end at a first side of the device housing (140), the device housing including a second mating end at a second side of the device housing, the connector health monitoring device further comprising a second testing probe (110) at the second mating end, wherein the first mating end has a first layout for mating with a first type of electrical connector (10) and the second mating end has a second layout for mating with a second type of electrical connector, optionally wherein the first mating end (112) is configured for mating with a CCS 1 charging connector and the second mating end is configured for mating with a NACS charging connector.

6. The connector health monitoring device (100) of any preceding claim, wherein the control element (160) includes a communication module (166) configured to communicate wirelessly, wherein the communication module transmits a health assessment signal based on the health assessment to a remote device.

7. The connector health monitoring device (100) of any preceding claim, further comprising a camera (180) held by the device housing (140) configured to image the testable contact of the electrical connector (10), wherein the control element (160) determines the health assessment based on images from the camera.

8. The connector health monitoring device (100) of any preceding claim, further comprising a lighting element (182) held by the device housing (140) configured to illuminate the testable contact of the electrical connector (10).

9. The connector health monitoring device (100) of any preceding claim, further comprising a wear sensor configured to determine wear of the testable contact of the electrical connector (10), wherein the control element (160) determines emissivity of the testable contact based on a signal from the wear sensor to predict wear of the testable contact of the electrical connector.

10. The connector health monitoring device (100) of any preceding claim, further comprising a user interface (190) coupled to the device housing (140), wherein the user interface optionally comprises a display (192), for example a touch-screen display.

11. The connector health monitoring device (100) of any preceding claim, wherein the control element (160) includes a first sensor for sensing a first health assessment characteristic of the testable contact and a second sensor for sensing a second health assessment characteristic of the testable contact different from the first health assessment characteristic.

12. The connector health monitoring device (100) of any preceding claim comprising a battery (168) coupled to the control element (160) to power the connector health monitoring device, or wherein the device housing (140) is handheld, for example including a handle (158).

13. The connector health monitoring device (100) of any preceding claim, wherein the testing probe (110) includes a pogo pin (118) configured to interface with the testable contact and the pogo pin optionally measures at least one of a mating force and an electrical resistance with the testing probe (110).

14. The connector health monitoring device (100) of any preceding claim, further comprising a proximity detector operably coupled to the control element (160) configured to detect proximity to the electrical connector (10) to control the control element.

15. The connector health monitoring device (100) of any preceding claim, wherein the testing probe (110) includes a low wear layer at the mating interface (102) to improve wear resistance, wherein the low wear layer is optionally a graphite layer.

16. The connector health monitoring device (100) of claim 5 or any claim dependent thereon, wherein the testing probe (110) is a first testing probe (110) and the mating interface is a first mating interface (102a) at the first mating end for mating with the testable contact of the electrical connector (16) of the first type, wherein the second testing probe is held by the device housing, the second testing probe including a second mating interface (102b) at the second mating end for mating with a testable contact of the electrical connector (18) of the second type; and wherein the control element (160) is operably coupled to the first testing probe to receive signals from the first testing probe and is operably coupled to the second testing probe to receive signals from the second testing probe, the processor (165) for performing a health assessment of the electrical connector (10) based on the received signals from the first testing probe or the second testing probe.

17. A method of monitoring health of a separable connector interface (12) of an electrical connector, the method comprising:
providing a connector health monitoring device (100) including a device housing (140) including a body (142) forming a cavity (150) and having a mating end (112) configured for mating with the electrical connector, the connector health monitoring device including a testing probe (110) held by the device housing at the mating end including a mating interface (102) for mating with a testable contact of the electrical connector, and the connector health monitoring device including a control element (160) received in the cavity operably coupled to the testing probe to receive signals from the testing probe, the connector health monitoring device (100) optionally being the connector health monitoring device of any preceding claim;
mating the testing probe with a testable contact of the electrical connector at the separable connector interface;
measuring a health assessment characteristic of the testable contact with the testing probe using a sensor of the control element; and
generating a health assessment at the control element of the testable contact based on the measured health assessment characteristic and optionally transmitting the health assessment to a remote device.

18. The method of claim 17, further comprising imaging the testable contact with a camera (180) prior to mating the testing probe (110) with the testable contact, wherein said generating a health assessment at the control element (160) of the testable contact is based on images of the testable contact.
